# EUROPEAN PATENT SPECIFICATION

(11) **EP 1 804 561 B1**
(45) Date of publication and mention of the grant of the patent: **28.01.2015**
(21) Application number: 05028733.3
(22) Date of filing: 30.12.2005
(51) Int. Cl.: H05K 3/36, H05K 3/40

(54) **Printed circuit board for perpendicularly connecting electronic components**
Leiterplatte zur senkrechten Verbindung elektronischer Bauelemente
Carte de circuit imprimé pour connection perpendiculaire de composants électroniques

(43) Date of publication of application: 04.07.2007
(73) Proprietor: Omron Europe B.V., 5234 GM 's-Hertogenbosch (NL)
(72) Inventor: Geitel, Stephan J., 5345 EB Oss (NL); Hunter Arjen D., 5665 GN Geldrop (NL)
(74) Representative: Hess, Peter K. G.

(56) References cited:
- EP-A- 0 766 507
- FR-A- 2 818 869
- US-A1- 2003 107 876
- US-B1- 6 496 384

## Description

### 1. Field of the invention

The invention relates to a printed circuit board for connecting with electronic components.

### 2. Prior art

In the prior art, connections between printed circuit boards and electronic components, like e.g. another printed circuit board, are typically established by means of board-to-board connectors. Such board-to-board connectors usually consist of a connector housing formed from insulating material with a conductive coating on the surfaces thereof and with cavities formed therein to receive corresponding terminals of the electronic component to be connected. Board-to-board connectors have several disadvantages. Board-to-board connectors are relatively expensive and they represent an additional part, which has to be assembled, thus increasing the complexity of the production process of the printed circuit board. Further they do not offer a high flexibility, since for each component which has to be connected a matching connector has to be provided.

Prior art document JP-8018188A of NEC Digata Ltd. proposes a connecting mechanism for printed circuit boards, wherein the commonly used connectors are not necessary. According to the JP-8018188 a first printed board is provided with a number of recesses and a second printed board is provided with a number of corresponding protrusions acting as terminal parts to connect the two printed circuit boards together. The recesses in the first printed board are provided in the form of throughholes for receiving the terminals of the second printed board. For a strong mechanical connection, the recesses are additionally provided with spring-like contact elements which clamp the terminal parts of the second printed board. Due to the clamping effect of the spring-like contact elements the two printed circuit boards are connected mechanically and at the same time an electrical connection is provided. However, this solution is relatively expensive and the production of such printed circuit boards is rather complex, since a large number of small separate parts, i.e. the spring-like contact elements, have to be mounted on the printed board.

Document US 6,496,384 discloses a printed circuit board assembly and in particular a method to provide a board-to-board connection of two printed circuit boards. To this end, it is suggested to provide one printed circuit board with a longitudinal slot suitable for receiving another printed circuit board and to provide the inner surface of this slot with several recesses adapted to be filled with solder material upon mounting of the two printed circuit boards with each other.

Document US 2003/0107876 A1 discloses a structure for mounting an electronic circuit unit on a motherboard without defective soldering. To this end, the motherboard is provided with three longitudinal slots being aligned on the same central line. The three slots are physically separated from each other and one slot serves as alignment means, whereas the other two slots serve for an electric coupling of the circuit unit to the motherboard.

It is an object of the present invention to overcome the disadvantages of the art. In particular, it is an object of the invention to provide a cost-efficient and mechanically stable connection between printed circuit boards and electronic components without the need for separate connectors.

These and other objects, which will derive from the following description, are solved by the present invention.

### 3. Summary of the invention

The above object is solved by a printed circuit board according to claim 1.

According to the invention, a printed circuit board is presented for connecting with electronic components, comprising at least one slot extending through the printed circuit board, which slot is suitable for receiving the electronic components. The inner surface of the at least one slot is provided with at least one recess extending from one side of the printed circuit board to the other. The recess or recesses act like a "channel" for the solder material - which is commonly used for connecting printed circuit boards with electronic components - such that the solder material is drawn into the recess by capillary force, substantially increasing the contact surface of solder material and the parts to be connected.

By providing a recess or preferably several recesses in the inner surface of the slot, a very advantageous solder connection between the printed circuit board and the electronic component can be achieved. Soldering is a method for joining parts using a filler metal (solder) of low melting point, usually below 450°C. The filler metal or solder is applied to the joint of the parts to be connected and subsequently heated until it liquefies. The liquefied material then spreads around the joint of the parts to be connected and is drawn to some extend into the joint by capillary action. When the liquefied solder material cools, it solidifies and provides a bond between the parts to be joined. The present invention uses the natural phenomenon of capillary action or capillarity by providing recesses in the inner surface of the slot extending from the underside to the upside of the printed circuit board. When an electronic component is plugged into the slot the recesses provide narrow channels or tubes between the inner wall of the slot and the walls of the plugged-in electric component. When solder material is applied on the joint between the printed circuit board and the plugged-in electronic component it flows into the recess and is drawn by capillary action into the recess until it preferably fills out the whole space provided by the recess. Thus a very strong bond between printed circuit board and electronic component is established, since the solder material is not only applied to the surface of the joint between board and component but it is also applied deep into the joint itself.

In a preferred embodiment, the recess is plated with a metal, preferably copper. The plating facilitates the solder process and improves the strength of the connection between the printed circuit board and the electronic component. The plated recesses are preferably provided with conductive traces, so that an electric connection between the printed circuit board and the electronic component can be achieved. The part of the electronic component that is inserted into the slot is in turn preferably provided with contacts, like e.g. copper elements, which contacts are arranged adjacent to the plated recesses, when the electronic component is inserted into the slot of the printed circuit board. In the following soldering step, the solder material fills the free space provided by the recesses between the inner surface of the slot and the inserted part of the electronic component. The solder material thus establishes an electrical connection between the copper plating of the recesses and the adjacent contacts on the electronic component.

In a preferred embodiment, the slot is provided with a plurality of recesses and the recesses are arranged pair-wise on opposing sides of the slot. When using for example five pairs of copper plated recesses provided with electro-conductive traces, the so-prepared slot may serve as a 10-point connection. The electronic component to be connected with the printed circuit board may e.g. be a second printed circuit board which is provided with a card-like connecting part, corresponding in size to the shape of the slot provided in the first printed circuit board. In a most preferred embodiment, the shape of the card-like connection part is shaped such that the inserted electronic component, like e.g. a second printed circuit board, is held inside of the slot by clamping force. Thus, the inserted electronic component is precisely positioned with respect to the first printed circuit board and in particular with respect to the recesses and electro-conductive traces provided on the first printed circuit board. At the same time, a sufficient mechanical connection is temporarily established between the first printed circuit board and the electronic component for the following soldering step, so that no further support structures or fixing means between the printed circuit board and the electronic component are necessary. The clamping force is preferably low enough, so that the inserted electronic component can e.g. be manually moved inside of the slot or removed. Most preferably the clamping force is just high enough to keep the component in position and just low enough to prevent excessive bending of the board which could lead to damages of the component and the board.

A further advantage of the inventive printed circuit board is that the connection is machine solder able, e.g. by wave soldering or selective soldering. In wave soldering, molten solder material inside of a tank is excited to form a standing wave. The printed circuit board is moved above the soldering tank so that the standing wave of the molten solder wets the exposed areas of the board, creating reliable electrical and mechanical connections between board and electronic components. Wave soldering can be used to solder through-hole components as well as surface mounted components. When using through-holes the electronic components are inserted into the board such that the contact elements of the components protrude to some extend from the underside of the printed circuit board. The printed circuit board is than run across the solder tank with its underside facing the standing wave, so that the solder material wets the joint of board and protruding component. The present invention is well suited for such a soldering process, since the capillarity draws the solder material against the force of gravity into the recess and keeps it there until it solidifies, even when the solder material is applied from the underside of the printed circuit board. To achieve good capillary forces the inner surface of the slot is preferably appropriately treated for a good wetting action. To increase the wetting copper may be applied to the inner surface of the slot. However, in a preferred alternative the surface tension of the solder material is lowered by a suitable flux material as it is common in soldering processes.

The slots and the respective recesses can be machined in the printed circuit board by means of conventional techniques, like for example milling or drilling, preferably by CNC machining. An exemplary method of manufacturing the inventive printed circuit board is to provide the board with at least one through-hole, preferably a number of throughholes positioned in one line. After that the through-holes may be plated with copper or other suitable electro-conductive material. The plated through-holes are preferably also provided with electro-conductive traces or tracks. In a next step, a slot is milled into the printed circuit board "connecting" the plated through-holes. The slot is milled with respect to the through-holes such that the holes build recesses in the form of rounded channels in the inner side walls of the slot. The slot extends preferably through the whole thickness of the printed circuit board, so that it provides a slot-shaped through-hole. The recesses run from one side of the printed circuit board to the other, more precisely from the underside of the printed circuit board to the upside.

### 4. Description of preferred embodiments

In the following preferred embodiments are exemplary described with reference to the enclosed figures, wherein
- Fig. 1: is a schematic part sectional view of a printed circuit board and an electronic component suitable for connecting with the printed board not in accordance with the invention;
- Fig. 2: is another schematic part sectional view of the printed circuit board when the electronic component is inserted therein;
- Fig. 3: is a schematic part sectional top view of the printed circuit board of Fig 1 with an electronic component inserted therein; and
- Fig. 4: is a sectional schematic side view of the printed circuit board with an electronic component inserted therein after having been soldered.
- Figs. 5A and 5B: show schematic views of further electronic components suitable for connecting with the printed circuit boards.
- Fig. 6A: is a schematic view showing the arrangement of slots on a printed circuit board in accordance with the invention.
- Fig. 6B: is an enlargement of the top right corner section of the printed circuit board of Fig. 6A.

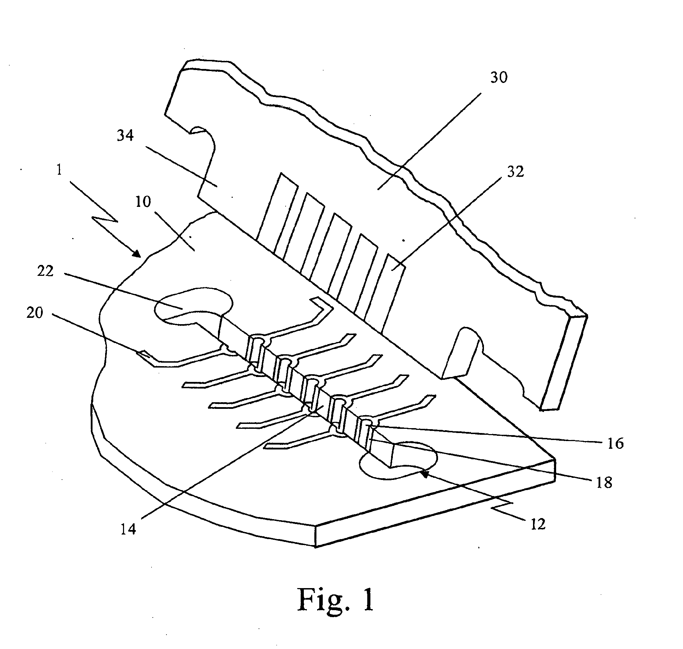

Fig. 1 shows a reference printed circuit board 1 in a schematic three-dimensional view. It should be noted that size and form of printed circuit board 1 is purely schematic to facilitate the understanding of the invention. In practice, the printed circuit board is usually much larger and provided with a plurality of elements and components as for example different connecting means, slots, throughholes, traces, chip sets, busses, capacitors, connecting wires, a CPU, controllers, etc. Into the substrate 10 of the printed circuit board 1, a slot 12 is machined, extending through the whole thickness of the substrate, thus providing an opening from the underside of the printed circuit board to the upside. The slot has for example a width of 1,2mm to 2,2mm. In the inner side walls 14 of the slot 12 a number of recesses 16 is provided. The recesses 16 are for example rounded half-channels with a radius of for example 0,5mm. In the example of Fig. 1 altogether ten recesses 16 are provided in the inner side wall 14 of slot 12. The recesses 16 are arranged in a pair-wise manner in opposing side walls of the slot. Reference number 18 indicates plating, for example of copper, provided on the inside of the recesses 16. The plating extends also for some amount to the left and to the right of the recesses covering the area of the inner side wall 14 of slot 12 next to the recesses. Plating 18 is connected to conductive traces 20 provided on the printed circuit- board, electrically connecting the plating 18 with different components on board 1. Slot 12 is provided on its opposing ends with cut-outs 22.

For illustrative purposes, in Fig. 1 additionally an electronic component 30 is shown. In the example of Fig. 1, the electronic component 30 is a second printed circuit board, which is to be connected with printed circuit board 1 of the invention. The electronic component 30 is provided with a connecting part 34 which protrudes from the electronic component 30 and has basically a card-like rectangular shape. The shape of the connecting part 34 is preferably such that it fits snugly into slot 12, such that electronic component 30 and printed circuit board 1 may be held together by means of clamping force. The connecting part 34 is additionally provided with electronic contacts 32, which are provided in the form of conductive copper plates. In the depicted example in Fig. 1, connecting part 34 is provided with ten contacts 32, five on each side of the card-like connecting part 34. The contacts 32 are positioned such that when connecting part 34 is inserted into slot 12, each contact 32 is arranged adjacent at a predefined distance to one of the recesses 16 and the respective plating 18. In this way, a 10-point connection between printed circuit board and electronic component can be realized.

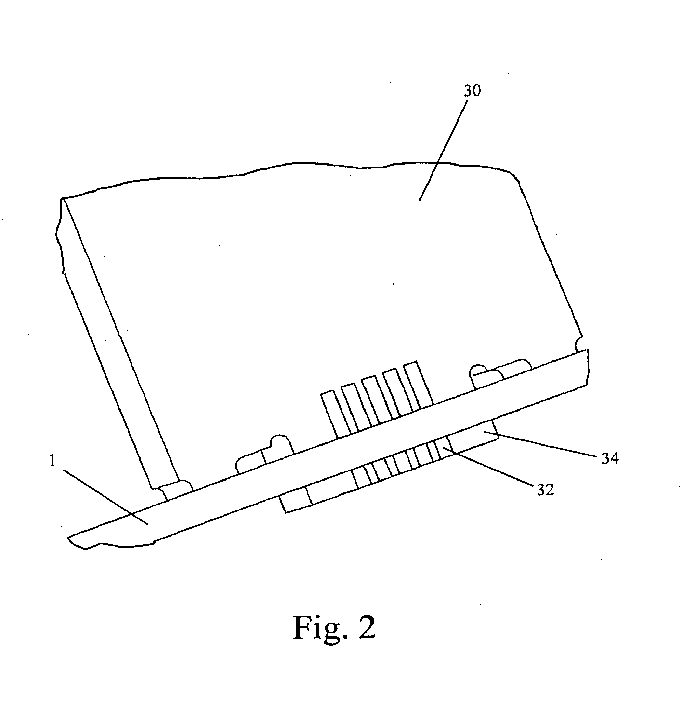

Fig. 2 shows exemplary in a schematic view the positioning of electronic component 30 with respect to the printed circuit board 1, when the electronic component, respectively the connecting part 34 of the same, is connected with the printed circuit board. The card-like connecting part 34 together with the contacts 32 protrudes somewhat from the underside of the printed circuit board 1. If the printed circuit board is e.g. machine soldered, the soldering can be applied from the underside of the printed circuit board to the joint between board and protruding connecting part 34. Due to capillary force a part of the liquid solder material will be drawn into the recesses thus providing a very stable solder connection.

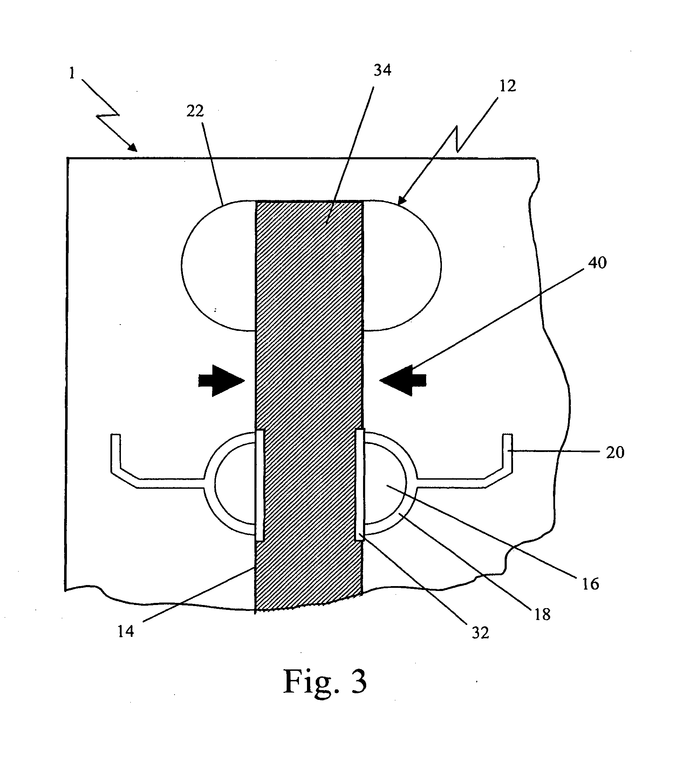

Fig. 3 shows a schematic plan view of the inventive circuit board 1 seen from the underside, when the card-like connecting part 34 of the electronic component 30 is inserted into slot 12. As can be seen from Fig. 3, the recesses 16 are arranged adjacent to the contacts 32 provided on the electronic component. In this position plating 18 partially contacts contact 32. The connecting part 34 fits snugly into slot 12 such that the side walls of slot 12 and connecting part 34 are in contact with each other. Slot 12 and connecting part 34 are preferably shaped such that the connecting part 34 is held inside of the slot by clamping force. The clamping force is indicated by arrows 40 in Fig. 3. The cut-outs 22 facilitate the plugging of the connecting part 34 into the slot 12.

After the soldering process, the space provided by recesses 16 between the side wall of the connecting part 34 of the electronic component 30 and the inner side walls 14 of the slot 12 of printed circuit board 1 is substantially filled with solder material. Thus the solder connection between printed circuit board and electronic component is considerably strengthened. Further, a large contact area between the contacts 32 and the plating 18 is provided, leading to a good electrical connection. As can clearly be seen from Fig. 3, the recesses 16 may have a rounded cross-section. Such a rounded cross sectional form assists the capillary action provided by the recess. However, also other shapes may assist the capillary action as it is well known to the person skilled in the art.

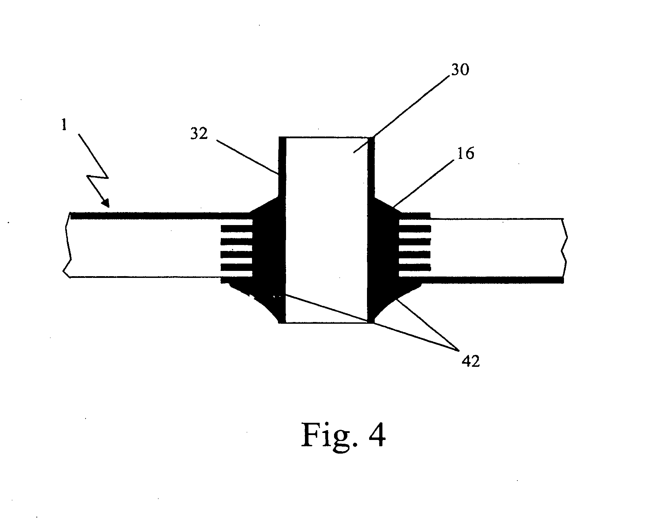

Fig. 4 shows the cross-section of the inventive printed circuit board 1, when electronic component 30 is fully inserted into the slot, and the soldering step is completed. Reference number 42 indicates solder material extending from the bottom side of the printed circuit board 1 through the recess 16 to the upper side of the board. Common solder connections are usually only present on the bottom side or the upper side of the printed circuit board. Due to the capillary force, the solder material fills substantially the whole space provided by the recess and it wets the joint between board and component on both sides of the board, i.e. on underside and upside. This through-board wetting gives the assembly additional strength and improved electrical connection between board and electronic component. The manufacturing of such a connection can be achieved by applying the solder material only on the bottom side of the printed circuit board, since the solder material is drawn by capillary force up through the recesses and spreads out for a certain amount on the upside of the board.

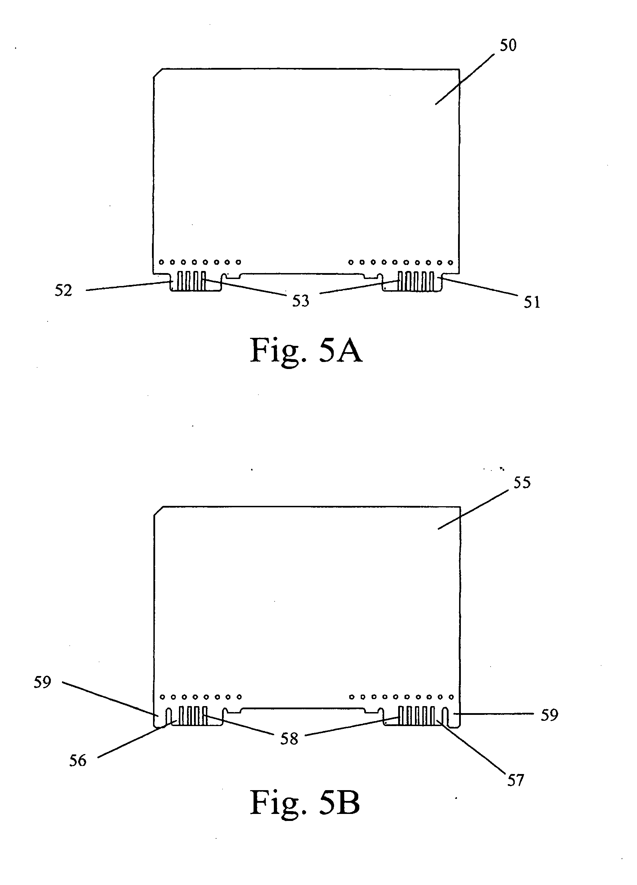

To facilitate the soldering process, it is highly desirable that the electronic components can temporarily be positioned in exact orientation with respect to the printed circuit board. For aesthetic reasons and to assist the soldering process it is highly preferable that the electronic components are arranged respectively mounted perpendicular with respect to the printed circuit board. This positioning of the electronic components should be easy to accomplish, allow a high degree of accuracy and be relatively cost efficient. Some preferred examples of positioning methods and arrangements will be explained in the following with reference to Figs. 5A to 6B.

Figs. 5A and 5B show two electronic components 50 and 55 to be plugged into a printed circuit board. In the examples of Fig. 5A and 5B the components 50, 55 are printed circuit boards; however other kinds of electronic components are also possible. Component 50 is on its lower side provided with two protruding connecting parts 51 and 52. The connecting parts 51, 52 have a basically card-like rectangular shape. The shape of the connecting parts 51, 52 is preferably such that it fits snugly into the slots provided on the printed circuit board. The connecting parts 51, 52 are further provided with electrical contacts 53.

Electronic component 55 is similar to component 50 and provided with connecting parts 56 and 57. The connecting parts 56, 57 are provided with electrical contacts 58 to allow for an electrical connection between component 55 and the printed circuit board. Component 55 differs from component 50 in that it is further provided with two positioning pins 59 next to the connecting parts.

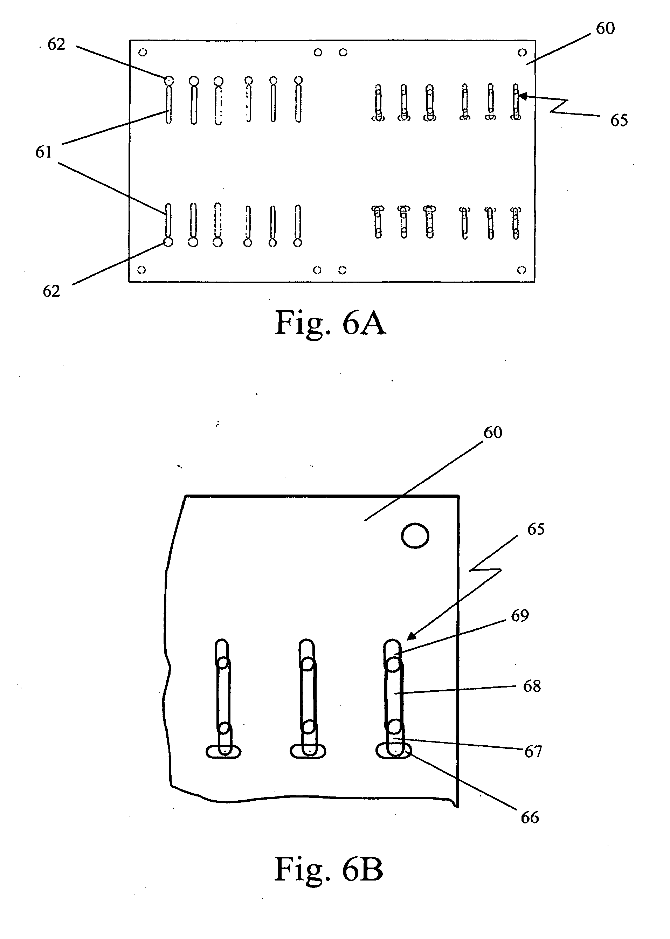

Fig 6A shows a printed circuit board 60 of the invention in a schematic view, which is provided with a number of slots for connecting with electronic components. Some or all of the slots may be provided with recesses as described above, however, for clarification purposes no recesses are shown in the figures. As can be seen from Fig. 6A the board 60 is provided with two different sets of slots on the left and the right side.

The slots 61 provided on the left side of board 60 are adapted to hold e.g. electronic component 55. When inserting electronic component 55 into board 60, the connecting part 56 is for example plugged into the upper left slot 61 and the connecting part 57 is plugged into lower left slot 61. Positioned adjacent to respective ends of the slots 61 through-holes 62 are provided in printed circuit board 60. The through-holes 62 are adapted to accommodate the positioning pins 59 provided on the electronic component 55. After the electric component 55 is plugged into the respective slots and through-holes, printed circuit board 60 and component 55 can be soldered together in a following solder step. For a precise positioning of component 55 with respect to board 60 before the solder step it is preferred that the shapes of slots 61, through-holes 62 and respective connecting parts 56, 57 and positioning pins 59 correspond to each other such that the component 55 fits snugly into the slots and through-holes. The clamping force existing between inserted component 55 and board 60 is preferably sufficient to hold component 55 in position until the soldering step. However, to achieve this, slots 61, through-holes 62 and the corresponding connecting parts 56, 57 and positioning pins 59 have to be produced with narrow tolerances. If the construction tolerances are not met, because one of the slots 61 is for example too wide or too narrow, an exact positioning of the electric component 55 on the board 60 is not possible.

The slot arrangement on the right side of board 60 shows the arrangement of slots to secure an electronic component according to the invention, like e.g. component 50, releasable in the board 60 before the soldering step. The slots on the right side of board 60 have the reference number 65. As can be seen from Fig. 6A and even better from Fig. 6B, which is an enlarged view of the upper right section of board 60 of-Fig. 6A, slots 65 do not have separate through-holes 62, and the electric component 50 to be inserted in slots 65 is in turn not provided with any positioning pins, like the positioning pins 59 provided on component 55. As can best be seen from Fig. 6b, slot 65 consists of a large main slot 68 which is provided on both distal ends with respective second and third slots 67 and 69. Additionally, a slot 66 is provided on the end of slot 67 in a perpendicular orientation to the same. Slot 66 assists in the correct positioning of connecting parts 51 and 52. Second and third slots 67, 69 are slightly offset with respect to the longitudinal centerline of slot 68. As can be seen from Fig. 6B, the offset of slots 67, 69 can be described as a zigzag orientation. The applicant has surprisingly found out that the provision of a slot 68 with such further offset slots 67, 69 advantageously facilitates the correct positioning of an electronic component. Due to the offset of the slots, the necessity for narrow tolerances of slots and respective connecting parts provided on the electronic component can be substantially decreased as compared to the slots depicted on the left side of board 60. Thus, the idea to provide a slot with a second slot on one end thereof oriented in the same direction and slightly offset with respect to the centerline of the first slot allows the application of less narrow tolerances, thus reducing the production costs of printed circuit boards and respective electronic components.

Preferably main slot 68 is provided with the above described recesses. However, recesses may also be provided on one or both of slots 67, 69.

The orientation shown in Fig. 6B of slots 67 and 69 in a zigzag fashion is the orientation in accordance with the invention, In non inventive embodiments, it is also possible to position slots 67 and 69 with a symmetric offset. For example, both slots 67 and 69 could be slightly offset to the left of the centerline of slot 68 or both to the right of the centerline of slot 68. The connecting parts provided on the electronic component are preferably shaped such that they snugly fit into the slots provided on the printed circuit board 60. Most preferably they are held inside of the slots in a manner, which allows for a stable mechanical positioning perpendicular to the printed circuit board.

The printed circuit board of the invention offers a large flexibility for connecting different electronic components. The number and positioning of recesses can be chosen quite freely to accommodate a large number of different components with differing numbers of connection points. Further by varying the cross-sectional shape of the recess a connection with different mechanical and electrical properties can be obtained. In the above-described example, a ten-point connection is disclosed; however, it is apparent to the person skilled in the art that different numbers of connection points can easily be achieved with the present invention.

## Claims

1. Printed circuit board (1; 60) for connecting with electronic components (30; 50; 55), comprising at least one slot (65) extending through the printed circuit board, suitable for receiving the electronic components, the inner surface (14) of the at least one slot is provided with at least one recess (16) extending from one side of the printed circuit board to the other, **characterized in that** the slot (65) consists of a main slot (68) which is provided on both distal ends with respective second (67) and third slots (69), the second and third slots are orientated in the same direction as said main slot (68) and slightly offset with respect to the centre line of said main slot (68), whereby one slot (67) is slightly offset to the right of the longitudinal center line of the main slot (68) and the other slot (69) is slightly offset to the left of the longitudinal center line of the main slot (68).

2. Printed circuit board according to claim 1, **characterized in that** the at least one recess (16) is plated (18) with copper.

3. Printed circuit board according to claim 1 or 2, **characterized in that** the at least one recess (16) has a rounded cross-section.

4. Printed circuit board according to any of the foregoing claims, **characterized in that** the at least one recess (16) is provided with conductive traces (20).

5. Printed circuit board according to any of claims 1 to 4, **characterized in that** a plurality of recesses (16) is provided along the length of the slot (65).

6. Printed circuit board according to any of the foregoing claims, **characterized in that** the shape of the slot (65) is chosen to receive an electronic component (30) with a clamping force to provide an initial temporary fixation to facilitate a soldering process.

7. Printed circuit board according to any of the foregoing claims, **characterized in that** the slot (65) is provided with cut-outs (22) on its opposing ends.

## Patentansprüche

1. Leiterplatine (1; 60) zum Verbinden mit Elektronikbauteilen (30; 50; 55), umfassend zumindest eine, sich durch die Leiterplatine erstreckende, zur Aufnahme eines Elektronikbauteils geeignete Aussparung (65), wobei
die Innenfläche (14) der zumindest einen Aussparung mit zumindest einer, sich von der einen Seite der Leiterplatine zu der anderen Seite erstreckenden Ausnehmung (16) versehen ist **dadurch gekennzeichnet, dass**
die Aussparung (65) aus einer Hauptaussparung (68) besteht, welche an beiden Distalenden mit entsprechenden zweiten (67) und dritten Aussparungen (69) versehen ist, wobei die zweiten und dritten Aussparungen in der gleichen Richtung ausgerichtet sind, wie die genannte Hauptaussparung (68) und in Bezug auf die Mittellinie der genannten Hauptaussparung (68) leicht versetzt sind, wobei eine Aussparung (67) leicht nach rechts von der Längsmittellinie der Hauptaussparung (68) und die andere Aussparung (69) leicht nach links von der Längsmittellinie der Hauptaussparung (68) versetzt ist.

2. Leiterplatine nach Anspruch 1 **dadurch gekennzeichnet, dass** die zumindest eine Ausnehmung (16) mit Kupfer plattiert (18) ist.

3. Leiterplatine nach einem der Ansprüche 1 oder 2 **dadurch gekennzeichnet, dass** die zumindest eine Ausnehmung (16) einen gerundeten Querschnitt aufweist.

4. Leiterplatine nach einem der vorhergehenden Ansprüche **dadurch gekennzeichnet, dass** die zumindest eine Ausnehmung (16) mit Leiterbahnen (20) versehen ist.

5. Leiterplatine nach einem der Ansprüche 1 bis 4 **dadurch gekennzeichnet, dass** eine Vielzahl von Ausnehmung (16) entlang der Länge der Aussparung (65) vorgesehen ist.

6. Leiterplatine nach einem der vorhergehenden Ansprüche **dadurch gekennzeichnet, dass** die Form der Aussparung (65) so gewählt wurde um ein Elektronikbauteil (30) mit einer Klemmkraft aufzunehmen und eine initiale, zeitweise Fixierung bereitzustellen um den Lötprozess zu vereinfachen.

7. Leiterplatine nach einem der vorhergehenden Ansprüche **dadurch gekennzeichnet, dass** die Aussparung (65) mit Ausschnitten (22) an ihren entgegengesetzten Enden versehen ist.

## Revendications

1. Carte de circuit imprimé (1 ; 60) à connecter avec des composants électroniques (30 ; 50 ; 55), comprenant au moins une fente (65) s'étendant au travers de la carte de circuit imprimé, apte à recevoir les composants électroniques, la surface intérieure (14) de la au moins une fente étant pourvue d'au moins un évidement (16) s'étendant d'un côté à l'autre de la carte de circuit imprimé, **caractérisée en ce que** la fente (65) consiste en une fente principale (68) qui est pourvue aux deux extrémités distales d'une seconde (67) et d'une troisième (69) fentes respectives, la deuxième et la troisième fentes étant orientées dans la même direction que ladite fente principale (68) et légèrement décalées par rapport à la ligne centrale de ladite fente principale (68), de sorte qu'une fente (67) soit légèrement décalée vers la droite de la ligne centrale longitudinale de la fente principale (68) et l'autre fente (69) soit légèrement décalée vers la gauche de la ligne centrale longitudinale de la fente principale (68).

2. Carte de circuit imprimé selon la revendication 1, **caractérisée en ce que** le au moins un évidement (16) est plaqué (18) de cuivre.

3. Carte de circuit imprimé selon la revendication 1 ou 2, **caractérisée en ce que** ledit au moins un évidement (16) présente une section droite arrondie.

4. Carte de circuit imprimé selon l'une des revendications précédentes, **caractérisée en ce que** le au moins un évidement (16) est pourvu de pistes conductrices (20).

5. Carte de circuit imprimé selon l'une des revendications 1 à 4, **caractérisée en ce qu'**il est prévu une pluralité d'évidements (16) sur l'étendue de la longueur de la fente (65).

6. Carte de circuit imprimé selon l'une des revendications précédentes, **caractérisée en ce que** la forme de la fente (65) est choisie pour recevoir un composant électronique (30) avec une force de pincement pour assurer une fixation temporaire initiale pour faciliter un processus de brasure.

7. Carte de circuit imprimé selon l'une des revendications précédentes, **caractérisée en ce que** la fente (65) est pourvue de découpes (22) à ses extrémités en vis-à-vis.
